(19) Europäisches Patentamt

European Patent Office

Office européen des brevets

(11) **EP 0 733 954 A2**

(12) **EUROPEAN PATENT APPLICATION**

(43) Date of publication:
25.09.1996 Bulletin 1996/39

(51) Int. Cl.$^6$: **G03F 7/095**, G03F 7/30

(21) Application number: 96104618.2

(22) Date of filing: 22.03.1996

(84) Designated Contracting States:
**DE GB**

(30) Priority: **24.03.1995 JP 91878/95**
**24.03.1995 JP 91879/95**

(71) Applicant: **FUJI PHOTO FILM CO., LTD.**
**Kanagawa (JP)**

(72) Inventor: **Nakao, Sho**
**c/o Fuji Photo Film, Co., Ltd.**
**Haibara-gun, Shizuoka (JP)**

(74) Representative: **Grünecker, Kinkeldey,**
**Stockmair & Schwanhäusser**
**Anwaltssozietät**
**Maximilianstrasse 58**
**80538 München (DE)**

(54) **Method and apparatus for processing photosensitive lithographic printing plate**

(57) A method for processing a photosensitive lithographic printing plate (PS plate) and an apparatus therefore, the method comprising subjecting the PS plate to imagewise exposure and development, the PS plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises the steps of (1) or (2):

(1) developing the silver halide photosensitive layer, without fixing the developed silver halide photosensitive layer, irradiating the PS plate with light for exposing the non-silver photosensitive layer through the silver halide photosensitive layer subjected to development and remaining unfixed, completing the irradiation such that the irradiation in every irradiated portion is within 3 seconds after the start of the irradiation, eluting the silver halide emulsion layer to remove, and finally developing the non-silver halide photosensitive layer, or (2) developing the silver halide photosensitive layer, without fixing the developed silver halide photosensitive layer, irradiating the non-silver photosensitive layer with light through the dried silver halide photosensitive layer, eluting the silver halide emulsion layer to remove, and finally developing the non-silver halide photosensitive layer.

Fig. 1

**Description**

FIELD OF THE INVENTION

The present invention relates to a method of processing a photosensitive lithographic printing plate and an apparatus for processing a photosensitive lithographic printing plate. More particularly, the invention is concerned with a method of processing a photosensitive lithographic printing plate which comprises a hydrophilic support, a water-insoluble ink-receptive non-silver photosensitive layer which is formed on the support and can form an ink-receptive image, and a silver halide photosensitive layer which is formed on the non-silver photosensitive layer, and an apparatus for the method.

BACKGROUND OF THE INVENTION

A photosensitive lithographic printing plate of the type which comprises a support having a water-wettable surface, e.g., an aluminum plate whose surface has been rendered water-wettable by a certain treatment, a non-silver photosensitive layer comprising an o-quinonediazide compound and a gelatin-silver halide photosensitive emulsion layer, which are arranged in that order, is known, e.g., in British Patent 1,227,603. A method of making a lithographic printing plate from such a photosensitive lithographic printing plate basically comprises steps of (a) subjecting a gelatin-silver halide photosensitive emulsion layer to imagewise exposure, (b) developing and fixing the emulsion layer to form a silver image therein, (c) subjecting a non-silver photosensitive layer arranged beneath the emulsion layer to the overall exposure, wherein the silver image formed functions as a mask, (d) removing the silver image-containing layer (i.e., the photosensitive emulsion layer which has undergone imagewise exposure, developing and fixing) by washing it out, and (e) developing the non-silver photosensitive layer.

In the aforementioned method for plate-making, i.e., the method of processing the photosensitive lithographic printing plate, it occurs that part of the blackened silver in the image area is rubbed off or transferred during the fixing operation in the step (b) and the transport to subsequent steps, resulting in adhesion to and accumulation on transport rollers, and finally transfer to the silver salt photosensitive layer or non-silver photosensitive layer of a separate photosensitive lithographic printing plate, thereby forming unintended opaque spots. If unintended opaque spots are formed in the non-silver photosensitive layer, unintended non-exposed areas are formed in the aforementioned overall exposure step (c), thereby forming a spotted image in the non-image area after the plate-making operation to result in generation of scum upon printing.

The above-described problem can be solved to a certain extent by providing a cleaning mechanism for the transport rollers installed in a fixing section and so on. However, such a solution not only renders the scale of the processing apparatus enormous, but also has a fear of failing to inhibit the aforesaid problem from relapsing under a long-term operation.

Hitherto, the fixation step has been considered essential for the aforementioned plate-making process since, if the fixation step is omitted, the unexposed area of the silver halide photosensitive layer is sensitized, developed and blackened in preference to the non-silver photosensitive layer in the overall exposure of the non-silver photosensitive layer to inhibit the non-silver photosensitive layer from substantially undergoing the exposure.

SUMMARY OF THE INVENTION

Therefore, an objects of the present invention is to provide a method of processing a photosensitive lithographic printing plate and an apparatus for the method, which enable the dissolution of the aforementioned problem caused by the silver eluted from a silver halide photosensitive layer in the fixation step, and ensure that the photosensitive lithographic printing plate can undergo development processing as it is kept clean.

The aforementioned object of the present invention is attained by the following embodiments (1) to (7):

(1) A method of processing a photosensitive lithographic printing plate comprising subjecting the photosensitive lithographic printing plate to imagewise exposure and development processing, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

development processing the silver halide photosensitive layer,
without fixing the developed silver halide photosensitive layer, irradiating the photosensitive lithographic printing plate with light for exposing the non-silver photosensitive layer through the silver halide photosensitive layer subjected to development processing and remaining unfixed,

completing the irradiation such that the irradiation in every irradiated portion is within 3 seconds after the start of the irradiation,

eluting the silver halide emulsion layer to remove, and

finally development processing the non-silver halide photosensitive layer.

(2) A method of processing a photosensitive lithographic printing plate as defined in the above embodiment (1), wherein the non-silver photosensitive layer is a positive working photosensitive layer containing a quinonediazide compound, and the silver halide photosensitive layer contains a negative working silver halide emulsion as a main component.

(3) An apparatus for development processing a photosensitive lithographic printing plate subjected to image exposure, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

(i) a first development section having only a means of feeding a developer to the imagewise exposed silver halide photosensitive layer, thereby performing the development,

(ii) an irradiation section having a means of emitting high-energy ultraviolet light and irradiating the whole surface of the non-silver photosensitive layer with the high-energy ultraviolet light at a time or divisionally through the silver halide photosensitive layer remaining unfixed such that the irradiation in every irradiated portion is within 3 seconds after the start of the irradiation,

(iii) an elution section for eluting the silver halide photosensitive layer out to remove, and

(iv) a second development section for developing the latent image formed in the non-silver photosensitive layer and dissolving the unnecessary portion to remove.

(4) A method of processing a photosensitive lithographic printing plate comprising subjecting the photosensitive lithographic printing plate to imagewise exposure and development processing, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

development processing the silver halide photosensitive layer,

without fixing, drying the developed silver halide photosensitive layer,

irradiating the non-silver photosensitive layer with light through the dried silver halide photosensitive layer,

eluting the silver halide emulsion layer to remove, and

finally development processing the non-silver halide photosensitive layer.

(5) A method of processing a photosensitive lithographic printing plate as defined in the above embodiment (4), wherein the developed silver halide photosensitive layer is dried until the content of the developer of the silver halide photosensitive layer is reduced to 50 % or less.

(6) A method of processing a photosensitive lithographic printing plate as defined in the above embodiment (4) or (5), wherein the non-silver photosensitive layer is a positive working photosensitive layer containing a quinonediazide compound, and the silver halide photosensitive layer contains a negative working silver halide emulsion as a main component.

(7) An apparatus for development processing a photosensitive lithographic printing plate subjected to image exposure, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

(i) a first development section having only a means of feeding a developer to the imagewise exposed silver halide photosensitive layer, thereby performing the development,

(ii) a drying section for drying the silver halide photosensitive layer, arranged subsequently to the development section,

(iii) an irradiation section for irradiating the non-silver photosensitive layer with light through the dried silver halide photosensitive layer,

(iv) an elution section for eluting the silver halide photosensitive layer out to remove, and

(v) a second development section for developing the latent image formed in the non-silver photosensitive layer and dissolving the unnecessary portion to remove.

In achieving the present invention, the present inventors have found a fact that when a silver halide photosensitive layer incorporated in the photosensitive lithographic printing plate is irradiated with light at a state moisten with a developer, development (blackening) of the silver halide photosensitive layer does not commence within about 3 seconds.

In the present embodiments (1) to (3), based on the aforementioned fact, the fixing of the developed silver halide photosensitive layer is not carried out and the irradiation is controlled so as to be finished within 3 seconds. Although the silver halide photosensitive layer is also exposed to light for irradiating the non-silver photosensitive layer, blackening of the silver halide photosensitive layer does not occur during the irradiation. Therefore, the non-silver photosensitive layer can be satisfactorily exposed to light in an imagewise pattern the silver halide photosensitive layer has.

In the present embodiments (4) to (7), on the other hand, since the silver halide photosensitive layer is dried after the developing step, the development in a non-exposed area of the silver halide photosensitive layer does not take place or proceeds very slowly even when the area is exposed to light for irradiating the non-silver photosensitive layer. Accordingly, the non-exposed area of the silver halide photosensitive layer does not become black during the irradiation, making it possible to conduct satisfactory exposure of the non-silver photosensitive layer.

Further, since fixing of the developed silver image is not effected, the non-silver photosensitive layer is subjected to the irradiation step under the condition that all the silver is retained in the silver halide photosensitive layer. In other words, separation of unnecessary silver does not occur before the non-silver photosensitive layer undergoes irradiation. Thus, the unintended formation of non-irradiated spots in the non-silver photosensitive layer due to adhesion of the separated unnecessary silver, as observed in conventional processing method having a fixation step, can be prevented in the irradiation step for the non-silver photosensitive layer. Accordingly, scum-free prints of very good quality can be obtained when printing is carried out using the lithographic printing plate prepared in accordance with the present invention.

Furthermore, since the fixing step is absent in the present invention, no fixer is used and the waste disposal upon fixation becomes unnecessary. Thus, considerable reduction in running cost can be made. In addition, the recovery of silver can be conducted easily according to the present invention, since the recovery of silver is made at a time in the step of washing out the silver halide photosensitive layer after the non-silver photosensitive layer is irradiated.

Additionally, JP-B-61-55667 (the term "JP-B" as used herein means an "examined Japanese patent publication") has such descriptions as "in the next place, the development of silver halide (first development) is carried out, and immediately thereafter or after processing with a fixer the non-silver photosensitive layer is irradiated with active rays", which implies the possibility of carrying out the irradiation without a fixing operation. However, it has no description of a substantial means to realize the possibility.

BRIEF DESCRIPTION OF DRAWINGS

Fig. 1 is a sectional view of part of a photosensitive lithographic printing plate used in the present invention.

Fig. 2 is a schematic diagram showing an example of the present processing apparatus for a photosensitive lithographic printing plate.

Fig. 3 is a sectional view illustrating an example of the structure of the irradiation section of the processing apparatus shown above.

Fig. 4 is a sectional view illustrating another example of the structure of the irradiation section of the processing apparatus shown above.

Fig. 5 is a schematic diagram showing another example of the present processing apparatus for a photosensitive lithographic printing plate.

Fig. 6 is a sectional view illustrating an example of the structure of the drying section of the processing apparatus shown in Fig. 5.

Fig. 7 is a sectional view taken on line A-A of the drying section shown above.

The symbols and figures used in the above illustrations represent the following:

PS: a photosensitive lithographic printing plate
1: a support
2: a non-silver photosensitive layer
3: a silver halide photosensitive layer
10: a processing apparatus for a photosensitive lithographic printing plate
20: a first development section
30: an irradiation section
40: an elution section
50: a second development section
60: a washing section
70: a gumming section
10': a processing apparatus for a photosensitive lithographic printing plate

20':      a first development section
30':      a drying section
40':      an irradiation section
50':      an elution section
60':      a second development section
70':      a washing section
80':      a gumming section

## DETAILED DESCRIPTION OF THE INVENTION

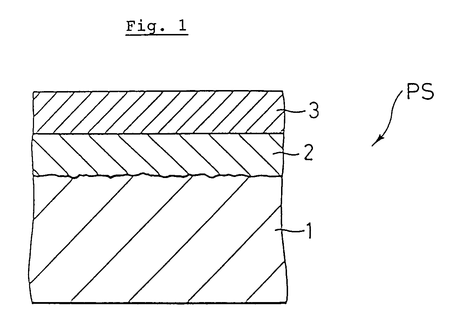

As shown in Fig. 1, a photosensitive lithographic printing plate used in the present invention (sometimes abbreviated as "PS", hereinafter) is basically constituted of a support 1 having a water receptive surface, a non-silver photosensitive layer 2 capable of forming an ink receptive image having no water wettability and a silver halide photosensitive layer 3, which are arranged in that order. In addition, the interlayer as described in U.S. Patent 3,245,793, U.S. Defense Patent Application T-870022, JP-B-47-23721, etc., or an interlayer containing a hydrophilic polymer such as gelatin, polyvinyl alcohol or polyvinyl imidazole can optionally be arranged between the non-silver photosensitive layer and the silver halide photosensitive layer, and a protective layer containing a water-soluble or hydrophilic polymer as cited above can be provided on the silver halide photosensitive layer, if needed. Further, other interlayers having particular compositions can also be provided, which will be described hereinafter.

The support which can be used in the present invention has a water receptive surface, and it may be any of supports which have so far been used for lithographic printing plates.

Specific examples of such a support include paper, paper laminated with plastics (e.g., polyethylene, polypropylene, polystyrene), metal plates (e.g., an aluminum plate, including aluminum alloy plates, a zinc plate, an iron plate, a copper plate), films of plastics such as cellulose diacetate, cellulose triacetate, cellulose propionate, cellulose acetate, cellulose butyrate acetate, cellulose nitrate, polyethylene terephthalate, polyethylene, polystyrene, polypropylene, polycarbonate, polyvinyl acetal, etc., and paper or plastic films on which a metal as cited above is laminated or deposited. Of these supports, an aluminum plate or a composite sheet comprising an aluminum sheet is preferred.

In order that the surface of a support as cited above may have water receptivity, the support has to receive some surface treatment or a water receptive layer must be provided thereon, if needed. In imparting water wettability to the support surface, various treatments can be adopted. In the case of a support having a plastic surface, the so-called surface treatments such as a chemical treatment, a discharge treatment, a flame treatment, an ultraviolet treatment, a high frequency wave treatment, a glow discharge treatment, an active plasma treatment and a laser treatment (as described, e.g., in U.S. Patents 2,764,520, 3,497,407, 3,145,242, 3,376,208, 3,072,483, 3,475,193 and 3,360,448, and British Patent 788,365), can be adopted. After undergoing a surface treatment as cited above, the support can be provided with a water receptive layer, if needed, as described in U.S. Patent 2,649,373, JP-A-53-40890 and JP-A-53-61643 (the term "JP-A" as used herein means an "unexamined published Japanese patent application").

As for the support having a metal surface, especially an aluminum surface, it is desirable that the support be subjected to a surface treatment such as a graining treatment, a dipping treatment in an aqueous solution of sodium silicate, potassium fluorozirconate, a phosphate, etc., and an anodic oxidation treatment. Further, it is advantageous to use an aluminum plate which is grained and then subjected to a dipping treatment in an aqueous solution of sodium silicate, as described in U.S. Patent 2,714,066, and an aluminum plate which is subjected to an anodic oxidation treatment and then to a dipping treatment in an aqueous solution of an alkali metal silicate, as described in U.S. Patent 3,181,461. The anodic oxidation treatment as cited above can be effected by passing electricity through an aluminum plate in one of a mixture of an aqueous or non-aqueous solution of an inorganic acid, such as phosphoric acid, chromic acid, sulfuric acid, boric acid, etc., an organic acid such as oxalic acid, sulfaminic acid, etc., or a salt of the acid. In particular, it is preferable for the anodic oxidation to be carried out by passing electricity through aluminum plate in an aqueous solution of phosphoric acid, sulfuric acid or a mixture thereof. In addition, the silicate electrodeposition as described in U.S. Patent 3,658,662 is also effective. Further, it is preferable to use the aluminum plate which is electrolyzed by alternating current in a hydrochloric acid electrolyte and then anodically oxidized in a sulfuric acid electrolyte, as described in British Patent 1,208,224. Furthermore, it is favorable for prevention of scum upon printing to provide a subbing layer constituted of a cellulose resin containing a water-soluble salt of metal, such as zinc or the like, on the aluminum plate anodically oxidized in the above-cited process, as described in U.S. Patent 3,860,426.

Examples of the non-silver photosensitive layer capable of forming an ink-receptive image, which is provided on the support mentioned above, includes photosensitive layers used in conventional photosensitive lithographic printing plates. The term "ink-receptive" used herein signifies repelling a fountain solution used upon printing and receiving oily ink. Such a photosensitive layer is constituted of a composition as described below:

(1) Composition Comprising Diazo Resin

While diazo resins represented by the condensates of p-diazodiphenylamine and paraformaldehyde may be soluble or insoluble in water, it is preferable to use those insoluble in water but soluble in a general organic solvent. Especially desirable diazo resins are compounds having at least two diazo groups per molecule, such as the condensates of p-diazophenylamine and formaldehyde or acetaldehyde which form salts by combining with, e.g., phenol, fluorocapric acid or a sulfonic acid, such as triisopropylnaphthalenesulfonic acid, 4,4-biphenyldisulfonic acid, 5-nitro-o-toluenesulfonic acid, 5-sulfosalicylic acid, 2,5-dimethylbenzenesulfonic acid, 2-nitrobenzenesulfonic acid, 3-chlorobenzenesulfonic acid, 3-bromobenzenesulfonic acid, 2-chloro-5-nitrobenzene-sulfonic acid, 2-fluorocaprylnaphthalenesulfonic acid, 1-naphthol-5-sulfonic acid, 2-methoxy-4-hydroxy-5-benzoyl-benzenesulfonic acid, paratoluenesulfonic acid, etc. Other desirable diazo resins include the condensates of 2,5-dimethoxy-4-p-tolylmercaptobenzenediazonium and formaldehyde, the condensates of 2,5-dimethoxy-4-morpholinobenzenediazonium and formaldehyde or acetaldehyde, having the salts cited above.

In addition, the diazo resins described in British Patent 1,312,925 are also desirable.

The diazo resin itself can be a photosensitive material constituting a non-silver photosensitive layer, but the combination use of the diazo resin with a binder is preferred.

As the binder, various high molecular compounds can be used, but preferred examples thereof include high molecular compounds containing functional groups such as hydroxy, amino, carboxyl, amido, sulfonamido, active methylene, thioalcohol, epoxy, etc. Specific examples of the preferred binders include shellac described in British Patent 1,350,521, the polymers having hydroxyethylacrylate or hydroxyethylmethacrylate units as main repeating units as described in British Patent 1,460,978 and U.S. Patent 4,123,276, the polyamide resin described in U.S. Patent 3,751,257, the phenol resin and the polyvinyl acetal resins, including polyvinyl formal resin and polyvinyl butyral resin, described in British Patent 1,074,392, the linear polyurethane resin described in U.S. Patent 3,660,097, the phthaloylated resin of polyvinyl alcohol, the epoxy resin prepared by condensation of bisphenol A and epichlorohydrin, amino group-containing polymers such as polyaminostyrenes, polyalkylamino(meth)acrylates, etc., and celluloses such as cellulose acetate, cellulose alkyl ethers, cellulose acetate phthalate, etc.

The content of the binder in the composition for forming a non-silver photosensitive layer is preferably from 40 to 95 % by weight. Reduction in the binder content (i.e., increase in the diazo resin content) naturally results in enhancement of the photosensitivity, but deteriorates storage stability. The optimum binder content is from about 70 to about 90 % by weight.

To a composition comprising a diazo resin, the additives such as phosphoric acid, dyes and pigments as described in U.S. Patent 3,236,646, can be added.

(2) Composition comprising quinonediazide compound

Of quinonediazide compounds, o-quinonediazide compounds are preferred, and o-naphthoquinonediazide compounds are more preferred. Examples thereof include those described in U.S. Patents 2,766,118, 2,767,092, 2,772,972, 2,859,112, 2,907,665, 3,046,110, 3,046,111, 3,046,115, 3,046,118, 3,046,119, 3,046,120, 3,046,121, 3,046,122, 3,046,123, 3,061,430, 3,102,809, 3,106,465, 3,635,709 and 3,647,443, and other many publications. Among them, o-naphthoquinonediazidosulfonic acid ester or o-naphthoquinonediazidocarboxylic acid ester of an aromatic hydroxy compound, and o-naphthoquinonediazidosulfonic acid amide or o-naphthoquinonediazidocarboxylic acid amide of an aromatic amino compound are preferably used. Of those esters, particularly superior ones are the product obtained by esterification reaction of o-naphthoquinonediazidosulfonic acid with pyrogallol-acetone condensate as described in U.S. Patent 3,635,709, the product obtained by esterification reaction of o-naphthoquinonediazidosulfonic acid or o-naphthoquinonediazidocarboxylic acid with the polyester having hydroxy groups on its terminals as described in U.S. Patent 4,028,111, and the product obtained by esterification reaction of o-naphthoquinonediazidosulfonic acid or o-naphthoquinonediazidocarboxylic acid with a p-hydroxystyrene homopolymer or a copolymer of p-hydroxystyrene and other copolymerizable monomers as described in British Patent 1,494,043.

The o-quinonediazide compounds can be used alone, but it is preferable to use them in combination with alkali-soluble resins. Suitable examples of such resins include phenolic resins of novolak type, such as phenol-formaldehyde resin, o-cresol-formaldehyde resin, m-cresol-formaldehyde resin and so on. As described in U.S. Patent 4,123,279, those phenolic resins can produce more desirable effect when they are used together with the condensates of formaldehyde and a $C_3$-$C_8$ alkyl-substituted phenol or cresol, such as t-butylphenol-formaldehyde resin. Such an alkali-soluble resin is used preferably in a proportion of from about 50 to about 85 % by weight, more preferably from 60 to 80 % by weight, based on the total weight of the photosensitive composition.

The photosensitive composition comprising an o-quinonediazide compound can further contain a pigment, a dye, a plasticizer and so on, if needed.

(3) Composition comprising photosensitive azide compound

Suitable photosensitive azide compounds are aromatic azide compounds, in which an azide group may be attached to an aromatic ring directly or via a carbonyl or sulfonyl group. The azide groups therein decompose upon exposure to light to produce nitrenes, and these nitrenes bring about various reactions to convert those compounds into insoluble matters. Preferred examples of the aromatic azide compound include compounds containing at least one of azidophenyl, azidostyryl, azidobenzal, azidobenzoyl, and azidocinnamoyl. Examples thereof include 4,4-diazidochalcone, 4-azido-4'-(4-azidobenzoylethoxy)chalcone, N,N-bis-p-azidobenzal-p-phenylenediamine, 1,2,6-tri(4'-azidobenzoxy)hexane, 2-azido-3-chloro-benzoquinone, 2,4-diazido-4'-ethoxyazobenzene, 2,6-di(4'-azidobenzal)-4-methylcyclohexanone, 4,4'-diazidobenzophenone, 2,5-diazido-3,6-dichlorobenzoquinone, 2,5-bis(4-azidostyryl)-1,3,4-oxadiasole, 2-(4-azidocinnamoyl)thiophene, 2,5-di(4'-azidobenzal)cyclo-hexanone, 4,4'-diazidodiphenylmethane, 1-(4-azidophenyl)-5-furyl-2-penta-2,4-diene-1-one, 1-(4-azidophenyl)-5-(4-methoxyphenyl)-penta-1,4-diene-3-one, 1-(4-azidophenyl)-3-(1-naphthyl)propene-1-one, 1-(4-azidophenyl)-3-(4-dimethylaminophenyl)-propane-1-one, 1-(4-azidophenyl)-5-phenyl-1,4-pentadiene-3-one, 1-(4-azidophenyl)-3-(4-nitrophenyl)-2-propene-1-one, 1-(4-azidophenyl)-3-(2-furyl)-2-propene-1-one, 1,2,6-tri(4'-azidobenzoxy)hexane, 2,6-bis-(4-azidobenzylidene-p-t-butyl)cyclohexanone, 4,4'-diazidodibenzalacetone, 4,4'-diazidostilbene-2,2'-disulfonic acid, 4'-diazidobenzalacetophenone-2-sulfonic acid, 4,4'-diazidostilbene-α-carboxylic acid, di-(4-azido-2'-hydroxybenzal)acetone-2-sulfonic acid, 4-azidobenzalacetophenone-2-sulfonic acid, 2-azido-1,4-dibenzenesulfonylaminonaphthalene, 4,4'-diazido-stilbene-2,2'-disulfonic acid anilide, and so on.

In addition to those low molecular weight aromatic azide compounds, the azido group-containing polymers as described in JP-B-44-9047, JP-B-44-31837, JP-B-45-9613, JP-B-45-24915, JP-B-45-25713, JP-A-50-5102, JP-A-50-84302, JP-A-50-84303 and JP-A-53-12984 are also used to advantage.

It is desirable for these photosensitive azido compounds to be used together with high molecular compounds as binders. Suitable binders are alkali-soluble resins, with examples including natural resins such as shellac, rosin, etc., novolak type phenolic resins such as phenol-formaldehyde resin, m-cresol-formaldehyde resin, etc., homopolymers of unsaturated carboxylic acids such as polyacrylic acid, polymethacrylic acid, etc., copolymers of those acids and other monomers copolymerizable therewith such as methacrylic acid-styrene copolymer, methacrylic acid-methylmethacrylate copolymer, styrene-maleic anhydride copolymer, etc., resins obtained by partially acetalating partially or completely saponified polyvinyl acetate with an aldehyde such as acetaldehyde, benzaldehyde, hydroxybenzaldehyde, carboxybenzaldehyde or so on, and polyhydroxystyrenes. Further, resins soluble in organic solvents, including cellulose alkyl ethers such as cellulose methyl ether, cellulose ethyl ether, etc., can be used as binders.

Such binders are preferably used in a proportion of about 10 to about 90 %, based on the total weight of the composition comprising a photosensitive azido compound.

To the composition comprising a photosensitive azido compound can be further added additives such as dyes, pigments, plasticizers (e.g., phthalates, phosphates, aliphatic carboxylic acid esters, glycols, sulfonamides), sensitizers (e.g., Michler's ketone, 9-fluorenone, 1-nitropyrene, 1,8-dinitropyrene, 2-chloro-1,2-benzanthraquinone, 2-bromo-1,2-benzanthraquinone, pyrene-1,6-quinone, 2-chloro-1,8-phthaloylnaphthalene, cyanoacridine), and so on.

(4) Composition comprising polymer having -CH=CH-C(O)-linkage in main chain or side chains

Examples of such a composition include: compositions comprising as a main component a photopolymer such as polyesters, polyamides and polycarbonates containing a -CH=CH-C(O)- linkage as a photosensitive group in their main or side chains (e.g., the compounds described in U.S. Patents 3,030,208, 3,707,373 and 3,453,237), those comprising as a main component photosensitive polyesters derived from (2-propenylidene)malonic acid compounds, such as cinnamylidenemalonic acid, and difunctional glycols (e.g., the photopolymers as described in U.S. Patents 2,956,878 and 3,173,787), and cinnamic acid esters of hydroxy group-containing polymers, such as polyvinyl alcohol, starch, cellulose and the like (e.g., the photopolymers as described in U.S. Patents 2,690,966, 2,752,372 and 2,732,301). In addition to the principal component as cited above, the composition can contain a sensitizer, a stabilizer, a plasticizer, a pigment, a dye and so on.

(5) Photopolymerizable composition comprising addition polymerizable unsaturated compound

This composition preferably comprises (a) a vinyl monomer containing at least two terminal vinyl groups, (b) a photopolymerization initiator, and (c) a polymer as a binder.

Examples of the vinyl monomer as the component (a) include acrylic or methacrylic acid esters of polyols, such as diethylene glycol (meth)acrylate, triethylene glycol di(meth)acrylate, pentaerythritol tri(meth)acrylate, trimethylolpropane tri(meth)acrylate, etc.; bis(meth)acrylamides, such as methylenebis(meth)acrylamide, ethylenebis(meth)acrylamide, etc.; and urethane group-containing unsaturated monomers, e.g., the reaction products of diol mono(meth)acrylates and diisocyanates, such as di(2'-methacryloxyethyl)-2,4-tolylenediurethane, di-(2'-acryloxyethyl)trimethylenediurethane, etc.

Examples of the photopolymerization initiator as the component (b) include carbonyl compounds, organic sulfur-containing compounds, persulfides, redox compounds, azo and diazo compounds, halogen compounds and photoreducing dyes as described in J. Kosar, Light Sensitive Systems, chapter 5. Specific examples of such a compound include those disclosed in British Patent 1,459,563.

With respect to a binder as the component (c), known various polymers can be used. Specific examples thereof are described in U.S. Patent 4,072,527. Further, the chlorinated polyolefins described in British Patent 1,459,563 are preferred.

The components (a) and (c) are preferably used at a ratio of (a) to (c) of from 1:9 to 6:4 by weight, and the component (b) is preferably used in a proportion of 0.5 to 10 % by weight based on the component (a).

The photopolymerizable composition can further contain a thermopolymerization inhibitor, a plasticizer, a dye and a pigment.

Of the above-described compositions for the non-silver photosensitive layer, the compositions (2), (3), (4) and (5) are more desirable, and the composition (2) is most desirable. Such a composition is dissolved in an organic solvent, and coated by an usual method so that the dry coverage thereof be from about 0.01 to 5 $g/m^2$.

The silver halide photosensitive layer used in the present invention contains a silver halide emulsion comprising silver halide grains which are usually used for recording and a hydrophilic colloid as a binder, e.g., gelatin or a derivative thereof, polyvinyl alcohol or a derivative thereof, a vinylimidazole-vinylpyrrolidone copolymer, etc.

The silver halide emulsion may be an ordinary negative emulsion, or a direct positive emulsion. As for the silver halide, the usual silver chloride, silver bromide, silver iodide or a mixture of two or more thereof can be used. The average grain size thereof is desirably from about 0.01 to 5 $\mu$m. Those grains can be subjected to chemical sensitization, such as sulfur sensitization, reduction sensitization or/and sensitization with a salt of precious metal, such as Ir, Rh, Pt, etc., and spectral sensitization with sensitizing dye so as to acquire proper sensitivity. Further, the latent-image distribution of the grains may be a surface latent type or an inside latent type. It is desirable that the silver halide photosensitive layer contains a substantially water-insoluble lipophilic resin being in the form of fine particle dispersion. The term "lipophilic resin" as used herein is intended to include resins defined as follows: A sample is prepared by coating on a support a resin to be examined in a thickness of at least 2 $\mu$m, and examined for contact angle $\theta$ of the resin surface. More specifically, in accordance with the captive bubble method, as suggested in the article published by Mitsuo Obana in "Insatsu Zasshi (Graphic Arts Magazine)", No. 25 (October, 1968), entitled "Wetting Phenomenon in Lithography", while the sample is soaked in 24°C water and the surface thereof is kept in contact with fine particles (bubbles) of kerosine, the contact angle of kerosine at the resin surface in water ($\theta_{o/w}$) is measured with a goniometer. In the similar manner, the contact angle of water at the resin surface in kerosine ($\theta_{w/o}$) is measured while the sample is soaked in kerosine and the surface thereof is kept in contact with water bubbles. When the difference between these contact angle $\theta = -[\theta_{o/w} - \theta_{w/o}]$ is a positive in a substantial sense, the resin examined is defined as a lipophilic resin.

Specific examples of such a substantially water-insoluble lipophilic resin include the resins cited as examples of a binder used in the aforementioned non-silver photosensitive layer, namely shellac, polyamide resins, phenolic resins, polyvinyl acetal resins, linear polyurethane resins, novolak-type phenolic resins, polyesters and photopolymers such as polyvinyl cinnamate, light-sensitive unsaturated polyesters, etc.

It is desirable for those lipophilic resins to be dispersed in a gelatin-silver halide emulsion in the form of fine particles having an average size of from 0.01 to 10 $\mu$m. Further, it is effective to use such resins in a proportion of from about 0.1 to 20 parts by weight, desirably from 1 to 10 parts by weight, more desirably from 2 to 5 parts by weight, to 10 parts by weight of the hydrophilic colloid in a gelatin-silver halide emulsion.

When the lipophilic resin is dispersed and incorporated in the silver halide photosensitive layer, the photosensitive layer can firmly adhere to the non-silver photosensitive layer being the lower layer, and can avoid troubles arising from peeling of the layer which may be caused in the course of drying the silver halide emulsion directly provided on the non-silver photosensitive layer.

The silver halide photosensitive layer which can be used in the present invention can contain any additive generally used.

It is desirable that the silver halide photosensitive emulsion as described above be coated at a dry coverage of from 1 to 10 $g/m^2$, particularly from 2 to 6 $g/m^2$. In coating the photosensitive emulsion, not only usual dip, air knife and curtain coating methods but also the hopper coating method described in U.S. Patent 2,681,294 and an extrusion coating method can be adopted.

Also, it is possible to provide an interlayer having a particular composition on the non-silver photosensitive layer and then to provide on the interlayer the photosensitive layer containing a silver halide photosensitive emulsion. The foregoing expression "particular composition" signifies the dispersion of lipophilic resin as defined above in a hydrophilic protective colloid as illustrated below.

Examples of the hydrophilic protective colloid to be used for the interlayer include hydrophilic high molecular compounds which can be incorporated in the silver halide emulsion. More specifically, proteins such as gelatin, gelatin derivatives including gelatin-grafted polymers, casein, albumin, etc., cellulose derivatives such as hydroxyethyl cellulose, carboxymethyl cellulose, etc., sodium alginate, starch derivatives, and homo- or copolymers such as partially acetylated polyvinyl alcohols, poly-N-vinylpyrrolidone, polyacrylic acid, polyacrylamide, polyvinyl imidazole, polyvinyl pyrazole, etc., and so on can be used. Examples thereof include the gelatin derivatives, the reaction products of gelatin with isocyanates, acid halides, acid anhydrides, and acrylonitrile epoxy compounds, vinylsulfonamides as described in U.S. Patents 2,614,928, 2,763,639, 3,132,945, 3,118,766, 3,186,846 and 3,312,553, JP-B-39-5514, and JP-B-42-26845, and the gelatin-grafted polymers as described in U.S. Patents 2,763,625, 2,831,767 and 2,956,884.

In the interlayer, it is desirable that a lipophilic resin be used in a proportion of 0.1 to 20 parts by weight per 10 parts by weight of the hydrophilic protective colloid. By this combined use, the interlayer can be uniformly coated on the non-silver photosensitive layer, and the photosensitive silver halide emulsion layer can be provided on the interlayer as well. Thus, a lithographic printing plate capable of providing prints of good quality without attended by deterioration of press life and ink-receptivity can be obtained. In this case, it is a matter of course that no lipophilic resin may be incorporated in the silver halide photosensitive layer.

A lithographic printing plate can be prepared in accordance with the present processing method, and that using the photosensitive lithographic printing plate having the constitution as illustrated above. In the plate-making, firstly the silver halide photosensitive layer undergoes imagewise exposure to form a latent image therein. The imagewise exposure may be carried out in any manner. In general, enlarging exposure with a negative film having an image, and exposure by scanning an image with laser can be employed.

The thus imagewise exposed photosensitive lithographic printing plate is processed with the present processing apparatus to obtain a printing plate.

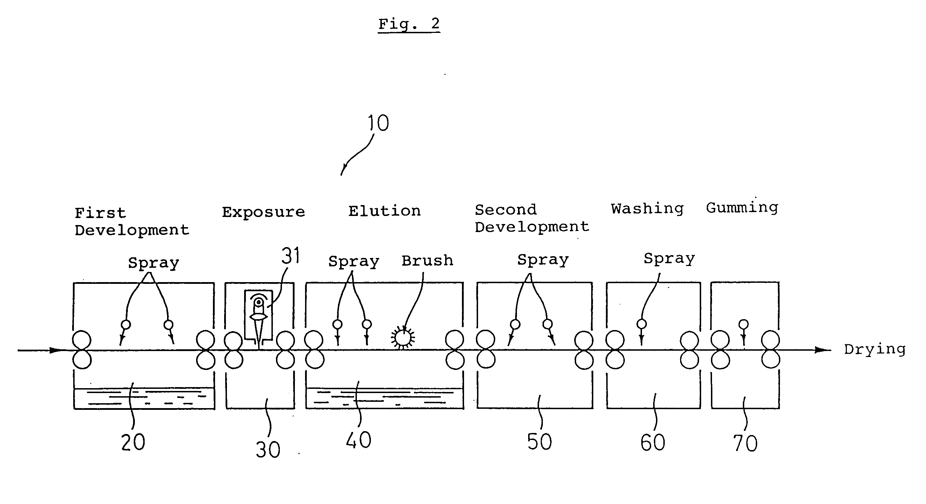

An example of the present apparatuses for processing photosensitive lithographic printing plates, which corresponds to the aforementioned embodiment (3), is illustrated below by reference to Fig.2. Additionally, the processing apparatus may be equipped with an exposure section for carrying out the foregoing imagewise exposure.

In Fig. 2, the numeral 10 represents a processing apparatus, and the processing apparatus 10 is provided with a first development section 20, an irradiation section 30, an elution section 40, a second development section 50, a washing section 60, and a gumming section 70, successively. All these sections including the foregoing imagewise exposure section are accommodated in a dark case.

In the first development section 20, a developer is fed to the silver halide photosensitive layer of a photosensitive lithographic printing plate, and develops the silver halide layer having a latent image.

This first development section 20 is characterized by the absence of fixing function, in contrast to conventional processing apparatuses for photosensitive lithographic printing plates. That is, development alone in a strict sense is carried out in the present first development section. Accordingly, no fixer is used in the first development section of the present invention, so neither fixer supplying nor recovering equipment is installed therein.

The development of the silver halide photosensitive layer can be conducted according to general methods for developing silver halide photosensitive materials.

Examples of a developing agent which can be used include hydroquinone, catechol, resorcinol, pyrogallol, and the exemplified compounds having as substituent(s) a halogen atom, an aryl group, an amino group, or a $C_1$-$C_6$ alkyl or alkoxy group.

The developer can further contain an alkali agent such as sodium hydroxide, potassium hydroxide, and triethanolamine, a pH buffer such as sodium carbonate, potassium carbonate, potassium silicate, and sodium tertiary phosphate, an antifoggant such as potassium bromide, mercapto compounds, and triazoles, a water softener such as EDTA and sodium polyphosphates, and a preservative such as sodium sulfite and ethanolamine.

The temperature of the developer is generally from 20°C to 50°C, preferably from 24°C to 40°C, and the development time is generally from 10 to 20 seconds, preferably from 10 to 40 seconds.

The supply of the developer to a photosensitive lithographic printing plate may be carried out by a spraying method, as shown in Fig. 2, or by dipping the photosensitive lithographic printing plate in a developer tank.

The photosensitive lithographic printing plate, of which the silver halide photosensitive layer has been developed in the first development section and not been fixed, is fed to the irradiation section 30 to undergo irradiation.

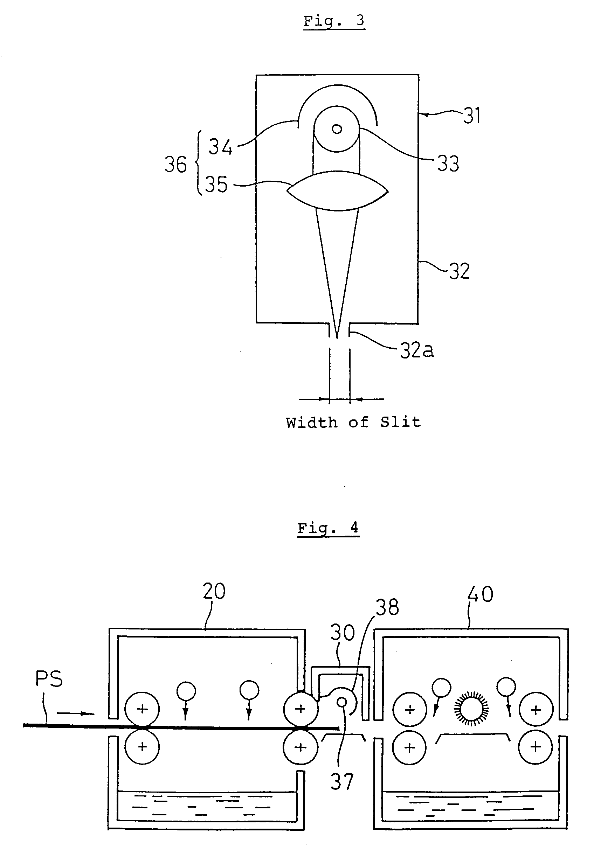

In the irradiation section, the non-silver photosensitive layer of the photosensitive lithographic printing plate is irradiated with light thorough the silver halide photosensitive layer subjected to imagewise exposure and development as a mask, with the irradiation time being within 3 seconds. The term "irradiation time" as used herein signifies the time for which irradiation with ultraviolet light is substantially given for every portion of the non-silver photosensitive layer. The aforesaid limitation to the irradiation time enables the non-silver photosensitive layer to receive irradiation even if the silver halide photosensitive layer is not fixed. The irradiation in the present invention is effected by exposing the photosensitive lithographic printing plate to high-energy ultraviolet light, and so the irradiation section 30 is equipped with a high-energy ultraviolet generator 31 comprising a mercury lamp or the like. Two examples of such a high-energy ultraviolet generator 31 are shown in Fig. 3 and Fig. 4.

The high-energy ultraviolet generator 31 shown in Fig. 3 is provided with a dark box 32 having a slit 32a which is open to the photosensitive lithographic printing plate PS, and in the interior of the dark box 32 are installed an ultraviolet lamp 33 such as a mercury lamp and a condenser 36 equipped with a curved reflex board 34 and a lens 35 for the conversion of the emitted light into a line-form slit light having a desired width.

It is desirable that the exposure energy H per unit area to be applied by the high-energy ultraviolet generator 31 be at least 0.3 $J/cm^2$, especially at least 1 $J/cm^2$. When the exposure energy H is less than 0.3 $J/cm^2$, it becomes difficult to complete the irradiation to the non-silver photosensitive layer within 3 seconds. The upper limit of the exposure energy is generally about 20 $J/cm^2$, since too intense exposure permits the passage of light through the image area to cause a fear of sharpening the image or skipping fine lines.

When the ultraviolet lamp 33 is a mercury lamp having a power of 1 kW and a length of 100 cm and the slit 32a has a width of 0.5 cm, the relation between the exposure energy H ($J/cm^2$) and the processing speed V (cm/sec) can be expressed by the following equation I;

$$\text{Exposure Energy H } (J/cm^2) = 1000 \ (W) \cdot \{0.5 \ (cm)/V \ (cm/sec)\}/0.5 \times 100 \ (cm^2) \qquad \text{Equation I}$$
$$= 10/V$$

Also, a flash-type irradiation equipment as shown in Fig. 4 can be used as the high-energy ultraviolet generator 31. The high-energy ultraviolet generator 31 as shown in Fig. 4 is equipped with a flash lamp 37, and the irradiation to the non-silver photosensitive material is carried out momentarily (for about 1/10 - 1/1000 second) with flashlight from the flash lamp 37. As the flash lamp used herein, a xenon flash lamp is preferred. Additionally, the figure 38 in Fig. 4 is a reflex board.

In addition, the high-energy ultraviolet generator 31 is provided with a control circuit (not shown in Fig. 4) for making the flash lamp 37 work intermittently at regular time intervals. Therein, it is desirable for the time interval to be selected so that the flash lamp 37 may work whenever the head of an unirradiated portion of the photosensitive lithographic printing plate which is transported continuously reaches the vicinity of the center of the irradiation section 30. Making additional remark, the irradiation with flashlight may be given repeatedly to the same portion. This is because the non-silver photosensitive layer is exposed to flashlight via the same image and, even if the flash working time interval is longer than 3 seconds, the silver halide photosensitive layer is blackened to inhibit further transmission of flashlight.

When the irradiation is performed with such flashlight, a substantial irradiation time (a time required for completing the irradiation in every portion) is generally from 1/10 to 1/100 seconds.

Furthermore, it is possible to use an ultraviolet laser device as the high-energy ultraviolet generator 31. In this case, the irradiation is performed by scanning the photosensitive lithographic printing plate with a spot of laser beams.

Although the irradiation section 30 having a high-energy ultraviolet generator 31 are described above, the high-energy ultraviolet generator 31 should not be construed as being limited to the above-described ones. In other words, such a generator may have any structure so far as it enables the non-silver photosensitive layer to be irradiated in a short time. Further, it is required to pay a particular attention to the shielding from light, since high-energy ultraviolet light is generated in the irradiation section. In particular, it is necessary to avoid the high-energy ultraviolet light from leaking into the development section for the previous step.

The thus irradiated photosensitive lithographic printing plate is then transported into an elution section 40. In this elution section, the whole silver halide photosensitive layer of the photosensitive lithographic printing plate (since no fixing operation is carried out in the present invention, the silver halide photosensitive layer is not in a conventional state such that either exposed or unexposed area is lost by elution, i.e., wash-out) is subjected to elution, i.e., the so-called wash-out operation. This wash-out operation is desirably carried out by supplying to the photosensitive lithographic printing plate a wash-out processing solution containing a protease.

The supply of the wash-out processing solution to a photosensitive lithographic printing plate may be carried out using a spraying method, as shown in Fig. 2, or by dipping the photosensitive lithographic printing plate in a wash-out processing solution tank.

Proteases which can be used are vegetable or animal enzymes capable of hydrolyzing proteins such as gelatin, with specific examples including ficin, papain, pepsin, trypsin and so on. Also, various commercial proteases can be used. For instance, Takamine, HT (trade name, a product of Miles Laboratories), Bioplase PN-4 (trade name, a product of Nagase Seikagaku Kogyo, K.K.), Pronase P (trade name, a product of Kaken Kagaku K.k.) and so on are examples of commercially available ones. These enzymes can be used alone or as a mixture of two or more thereof. Further, the proteases capable of hydrolyzing gelatin as described, e.g., in JP-B-45-36205, JP-A-52-97738, Research Disclosure, No. 15025, British Patents 1,179,769 and 1,354,186, U.S. Patents 3,515,551, 3,565,618, 3,620,737 and 382178 can be used in the present invention. It is desirable for such a protease to have a concentration of from 0.001 to 10 % by weight in the wash-out processing solution.

The temperature of the processing solution is generally at a temperature of from 20°C to 60°C, preferably from 30°C to 50°C. The processing time is generally in the range of 10 to 60 seconds, preferably from 10 to 30 seconds.

This solution can be admixed with an inorganic salt such as calcium chloride, zinc chloride, sodium sulfite, etc., an organic acid salt such as sodium citrate, sodium acetate, etc., and an agent for rupturing polypeptide hydrogen bonds such as urea, the derivatives thereof, potassium thiocyanate, etc.

In the above-described manner, the whole silver halide photosensitive layer is washed out by only one operation, and all the silver to be recovered is contained in the wash-out processing solution, with most of the silver being present in the form of black silver. Thus, the recovery work of silver becomes very easy.

The photosensitive lithographic printing plate which has undergone the wash- out processing of the silver halide photosensitive layer is preferably cleaned with water and a brush or the like.

The protease may be incorporated in the silver halide photosensitive layer. In this case, a protease rendered inert, e.g., to gelatin is previously incorporated in the silver halide photosensitive layer. More specifically, a protease treated with a solution having a low pH value (e.g., not higher than 4) adjusted with sulfuric acid is incorporated in the silver halide photosensitive layer which retains its low pH, and water is used as the wash-out processing solution. Water is supplied to the silver halide photosensitive layer to raise the pH of the photosensitive layer, so that the protease is activated to degrade protein such as gelatin.

The thus processed photosensitive lithographic printing plate, of which the silver halide photosensitive layer has been washed out, is transported to a next second development section 50 to effect the development of the non-silver photosensitive layer. More specifically, in order to obtain a lithographic printing plate, a developer suitable for the non-silver photosensitive material is supplied to the non-silver photosensitive layer, and thereby either unexposed or exposed area of the layer is dissolved and removed to result in exposure of the water receptive surface of the support. As for the developer supply, in analogy with the first development section, the spraying or dipping method are preferably used.

The developer for the non-silver photosensitive material is a processing solution capable of dissolving selectively either exposed or unexposed area of the non-silver photosensitive layer, and can be selected from conventional developers used for development of PS plates or developers analogous thereto. For instance, a aqueous solution of sodium silicate and the developers as described in U.S. Patent 4,141,733 can be used for the non-silver photosensitive layer comprising an o-quinonediazide compound. In the case where the non-irradiated area is dissolved (a negative working non-silver photosensitive layer), developers for negative working PS plates, e.g., the developers of aqueous alkali solution type as described in JP-B-04-28296 are used.

The second development can be effected by using a developer suitable for the non-silver photosensitive layer. The development temperature is generally from 15°C to 50°C, preferably from 15°C to 40°C, and the development time is generally from 10 to 120 seconds, preferably from 10 to 45 seconds.

The thus prepared lithographic printing plate is cleaned by water spray or the like in a washing section 60, and the surface thereof is preferably subjected to a general gumming treatment in a gumming section 70. Thus, all the operations are finished.

Printing with this lithographic printing plate is performed in a conventional manner after the gum at the plate surface is removed.

In the above description of platemaking, the processing apparatus shown in Fig. 2 is used, but the present invention should not be construed as being limited to that processing apparatus.

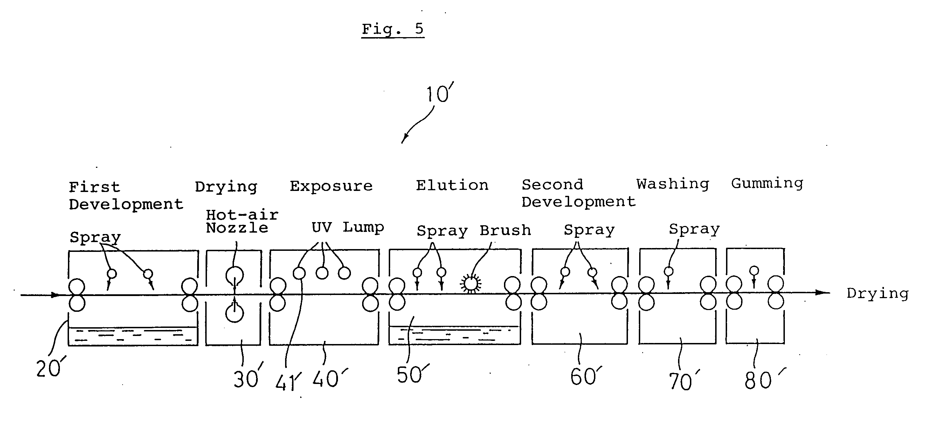

Another example of the present apparatuses for processing photosensitive lithographic printing plates, which corresponds to the aforementioned embodiment (7), is illustrated below by reference to Fig. 5. Additionally, this processing apparatus may be equipped with an exposure section for carrying out the foregoing imagewise exposure.

In Fig. 5, the figure 10' represents a processing apparatus, and the processing apparatus 10' is provided with a first development section 20', a drying section 30', an irradiation section 40', an elution section 50', a second development section 60', a washing section 70', and a gumming section 80', successively. All these sections in addition to the foregoing imagewise exposure section are accommodated in a dark case.

In the first development section 20', a developer is fed to the silver halide photosensitive layer of a photosensitive lithographic printing plate, and develops the latent image of the silver halide layer.

This first development section 20' is characterized by the absence of fixing function, in contrast to conventional processing apparatuses for photosensitive lithographic printing plates. That is, development alone in a strict sense is carried out in the present first development section. Accordingly, no fixer is used in the first development section of the present invention, and neither fixer supplying nor recovering equipment is installed therein.

The development of the silver halide photosensitive layer can be conducted as mentioned above. The developer temperature is generally from 20°C to 50°C, preferably from 24°C to 40°C, and the development time is from 10 to 20 seconds, preferably from 10 to 40 seconds.

The developer supply to a photosensitive lithographic printing plate may be carried out using a spraying method, as shown in Fig. 5, or by dipping the photosensitive lithographic printing plate in a developer tank.

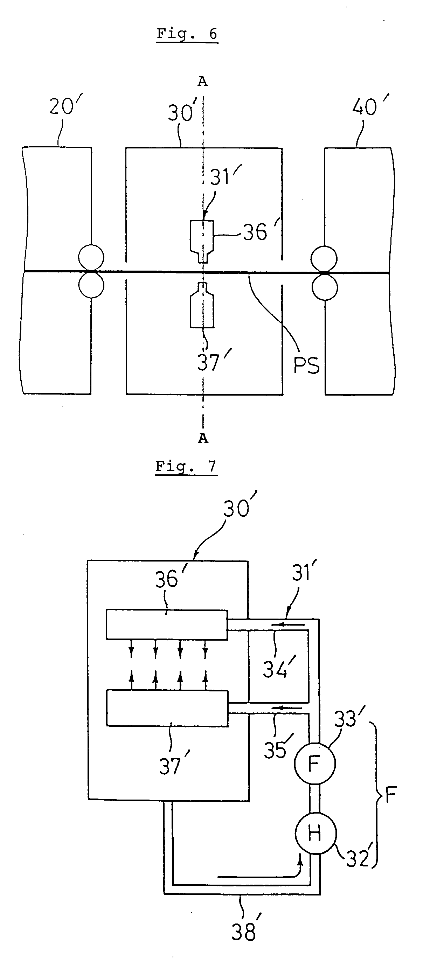

The photosensitive lithographic printing plate whose silver halide photosensitive layer has been developed in the first development section 20' is fed to the drying section 30' as it is in an unfixed state, and dried therein. The drying section 30' is provided with a drying equipment 31'. It is desirable for the drying equipment 31' to be an equipment of the type which produces a hot-air current, e.g., as shown in Fig. 6 and Fig. 7, wherein heated air currents generated by a heated air generator F comprising a heater 32' and a fan 33' are blowing upon both sides of a photosensitive lithographic printing plate from nozzles 36' and 37' via ducts 34' and 35'. In the drying section, drying is carried out by feeding warm- or hot-air having a temperature of from about 20° to about 100°C and in an air flow of from 1 to 50 m$^3$/min for a period of about 2 to about 20 seconds. Therein, it is desirable that the developer content in the silver halide photosensitive layer be reduced to 50 % or less, preferably 30 % or less, on the developer content therein just after development. Such a reduction of a developer content is conducted such that development in the non-image area does not take place in a substantial sense and the area other than the imagewise exposed area of the silver halide photosensitive layer is not blackened in the subsequent steps, particularly in the irradiation step. Additionally, the developer content has no particular lower limit, but the lower limit is generally about 5 %.

The terminology "developer content" as used in the present invention is defined as follows: The weight of a photosensitive lithographic printing plate is measured before the first development, and is designated as "Weight I". Immediately after the completion of the drying operation which follows the first development (the development of the silver halide photosensitive layer), the weight of the plate is measured, and is designated as "Weight II". Finally, the weight of the plate which has finished successively the irradiation of the non-silver photosensitive layer, the elution of the whole silver halide photosensitive layer and the drying operation, is measured and is designated as "Weight III". The developer content of the silver halide photosensitive layer at the measurement of Weight II can be calculated using those measured values and according to the following equation;

$$\text{Developer content} = (\text{weight II} - \text{weight I}) / (\text{weight I} - \text{weight III})$$

From the numerator (weight II - weight I) in the above equation, the developer weight on the measurement of weight II can be seen; while the weight of the silver halide photosensitive layer in itself can be seen from the denominator (weight I - weight III).

The feeding of air to the foregoing heated air generator F is carried out using a duct 38' connected with the drying section 30', and the heated air is preferably circulated in order to effectively use the heat. Further, for the purpose of effective use of the heat generated in the irradiation step, the air used for cooling the irradiation section can be admitted into the drying section.

Additionally, the back surface of a photosensitive lithographic printing plate, i.e., the surface of the support of a photosensitive lithographic printing plate (e.g., an aluminum plate), may be heated by using hot rollers as some of transporting rollers. On the other hand, no hot rollers are used for heating the face surface of the photosensitive lithographic printing plate, i.e, the surface of the silver halide photosensitive layer. This is because surface properties of the silver halide photosensitive layer are deteriorated by contact with hot rollers. Although it is a rare case, the use of an infrared-sensitive material in a non-silver photosensitive material gives rise to sensitization of the material even by heating, e.g., with a hot-air current. In such a case, it is desirable to carry out the drying operation only by ventilation (wherein an air temperature is 50°C or less, preferably from about 20 to 30°C).

The photosensitive lithographic printing plate thus dried in the drying section is transported into the next irradiation section 40'.

In the irradiation section 40', overall irradiation is given to the non-silver photosensitive layer of the photosensitive lithographic printing plate, wherein the silver halide photosensitive layer which has undergone successive imagewise exposure, development and drying operations functions as a mask. The irradiation is generally effected by irradiating the photosensitive lithographic printing plate with ultraviolet light. Thus, the irradiation section 40' is provided with a ultraviolet generator 41' such as a mercury lamp and a fluorescent lamp. The ultraviolet generator 41' may be any of means capable of emitting ultraviolet light, and a metal halide lamp, a xenon lamp and a carbon arc lamp as well as the mercury and fluorescent lamps can be used.

The thus irradiated photosensitive lithographic printing plate is transported into the next elution section 50'. In the elution section 50', all the silver halide photosensitive layer in the photosensitive lithographic printing plate is subjected to elution, i.e., the so-called wash-out operation. This wash-out operation is desirably carried out by supplying a wash-out processing solution containing a protease to the photosensitive lithographic printing plate. The supply of the wash-out processing solution to a photosensitive lithographic printing plate may be carried out using a spraying method, as shown in Fig. 5, or by dipping the photosensitive lithographic printing plate in a wash-out processing solution tank. As for the wash-out processing solution and proteases contained therein, those recited hereinbefore can also be used.

In the above-described manner, the whole silver halide photosensitive layer is washed out by only one operation, and all the silver to be recovered is contained in the wash-out processing solution. Thus, the recovery work of silver becomes very easy.

The photosensitive lithographic printing plate which has undergone the wash- out processing of the silver halide photosensitive layer is preferably cleaned with water and a brush or the like.

The thus processed photosensitive lithographic printing plate, of which the silver halide photosensitive layer has been washed out, is transported into the next second development section 60', and the development of the non-silver photosensitive layer is performed. In this development, a developer suitable for the non-silver photosensitive material is supplied to the non-silver photosensitive layer to remove a non-image area of the layer by dissolution therein; as a result, the water receptive surface of the support comes to be exposed. Thus, a lithographic printing plate is obtained. As for the developer supply, in analogy with the foregoing first development section, it is desirable to adopt methods of spraying a developer or dipping in a developer tank.

Suitable examples of a developer used for the non-silver photosensitive material include those recited hereinbefore.

The second development can be effected by using a developer suitable for the non-silver photosensitive layer. The development temperature is generally from 15°C to 50°C, preferably from 15°C to 40°C, and the development time is generally from 10 to 120 seconds, preferably from 10 to 45 seconds.

The thus prepared lithographic printing plate is cleaned by water spray or the like in a washing section 70', and the surface thereof is preferably subjected to a general gumming treatment in a gumming section 80'. Thus, all the operations are finished.

Printing with this lithographic printing plate is performed in a conventional manner after removal of the gum on the plate surface.

In the above description of platemaking, the processing apparatus shown in Fig. 5 is used, but the present invention should not be construed as being limited to that processing apparatus.

Now, the present invention will be illustrated in more detail by reference to the following examples. Unless otherwise noted therein, all % are by weight.

EXAMPLE 1

A 2S-class aluminum plate mechanically grained in accordance with the method described in JP-A-48-33911 was dipped for 1 minute in a 2 % aqueous solution of sodium hydroxide kept at 40°C, and thereby part of the plate surface was etched. After washing, the plate was dipped for about 1 minute in a sulfuric acid-chromic acid mixed solution to reveal the surface of pure aluminum. The thus treated aluminum plate was dipped in 20 % sulfuric acid kept at 30°C and was subjected to 2-minute anodic oxidation under a D.C. voltage of 1.5 V and an electric current density of 3 $A/dm^2$. Then, the aluminum plate was washed and dried. The photosensitive solution (I) having the following composition was continuously applied so as to have a dry coverage of about 2 $g/m^2$ by means of a roll coater, thereby forming a non-silver photosensitive layer on the aluminum plate.

Photosensitive Solution (I):

| | |
|---|---|
| Naphthoquinone-1,2-diazido(2)-5-sulfonic acid ester of acetone-pyrogallol resin (prepared by the method of Example 1 of U.S. Patent 3,635,709) | 2.5 g |
| Hitanol #3110 (cresol-formaldehyde resin, produced by Hitachi Chemical Co., Ltd.) | 5.0 g |
| Methyl ethyl ketone | 75 g |
| Cyclohexane | 60 g |

On the non-silver photosensitive layer, another photosensitive solution (II) having the following composition was continuously coated so as to have a dry coverage of about 4.5 $g/m^2$, and dried with hot air as the air temperature was raised finally to 110°C. The thus obtained photosensitive lithographic printing plate was designated as Sample No. 1.

Photosensitive Solution (II):

| | |
|---|---|
| Emulsion prepared by dissolving 45 g of a phenol -formaldehyde resin, MP120HH (trade name, a product of Gun-ei Kagaku Kogyo K.K.) in a mixture of 330 g of ethyl acetate and 120 g of methyl ethyl ketone to obtain a resin solution, and then dispersing this resin solution into a solution prepared by admixing 600 ml of a 10 % aqueous solution of gelatin with 60 ml of a 10 % aqueous solution of sodium nonylbenzene-sulfonate and 150 ml of a 10 % methanol solution of Turkey red oil | 1,300 g |
| Silver chlorobromide-gelatin emulsion (having a chloride content of 70 mole%, a bromide content of 30 mole % and an average grain size of 0.28 $\mu$m, and containing 55 g of gelatin and 0.85 mole of silver halide per 1 kg of emulsion) | 2,000 g |
| 0.1 % Methanol solution of sodium salt of 1,3-di-ethyl-5-[2-{3-(3-sulfopropyl)benzoxazol-2-ylidene}ethylidene]thiohydantoin | 100 ml |
| 0.5 % Alkaline aqueous solution of 4-hydroxy-6-methyl -1,3,3a,7-tetrazaindene | 200 ml |
| 2 % Aqueous solution of 2,4-dichloro-6-hydroxy-s-triazine | 70 ml |

The photosensitive lithographic printing plate (Sample No. 1) was allowed to stand for 1 week under room temperature, and then subjected to the following platemaking processing: Sample No. 1 was exposed to light for 10 seconds via a negative film, which had been prepared by taking a photograph of letters on a reduced scale of about one-fifth, by means of an enlarger equipped with a 300 lux of light source and adjusted so as to magnify images 5 times. While it was continuously transported at a transportation speed of 1,000 mm/min, the thus exposed photosensitive lithographic printing plate was subjected to the following processing by means of a processing apparatus having the structure shown in Fig. 2 and Fig. 3. In the first development section, a developer (I) having the following composition was warmed to 32°C and sprayed onto Sample No. 1 for 20 seconds. Subsequently, irradiation was carried out by means of a high-energy ultraviolet generator 31 in the irradiation section. This high-energy ultraviolet generator 31 was provided with a 1 kW mercury lamp having a length of 1 m as an ultraviolet lamp, and enclosed in a dark box having a slit having a width of 5 mm and a length of 1,000 mm. The light emitted from the ultraviolet lamp was condensed by the use of a reflex plate and a lens so as to be within the slit width, and the photosensitive lithographic printing plate was irradiated with the thus condensed light.

From the equation I mentioned hereinbefore (wherein the processing speed was 1,000 mm/min because the transportation speed was 1,000 mm/min as described above), it was determined that the exposure energy was about 6 J/cm$^2$ and the irradiation completion time in every portion of the photosensitive lithographic printing plate was about 0.3 second.

Thereafter, in the elution section, the irradiated plate was sprayed with a 40-45°C wash-out solution having the composition described below, and then rubbed with brushes, followed by being made to pass between squeegee rollers. Further, the plate was transported into the second development section, and therein a 30°C developer (II) having the following composition was sprayed onto the plate for 30 seconds. The thus processed plate was washed in the washing section, and then coated with GP-1 by means of a gum coater 800 G (made by Fuji Photo Film Co., Ltd.) in the gumming section to provide a printing plate A.

Composition of Developer (I):

| Water | 700 ml |
|---|---|
| Metol | 0.3 g |
| Sodium sulfite | 45.0 g |
| Hydroquinone | 12.0 g |
| Sodium carbonate (monohydrate) | 80.0 g |
| Potassium bromide | 2 g |
| Water to make | 1 liter |

The foregoing developer was a stock solution, and so it was diluted with the twice amount of water when used actually.

Composition of Developer (II):

| JIS No. 1 sodium silicate | 100 g |
|---|---|
| Sodium metasilicate | 50 g |
| Purified water | 1,800 ml |

Composition of Wash-Out Solution:

| Bioplase PN-4 | 5 g |
|---|---|
| Water | 1,000 ml |

On the other hand, a printing plate B was prepared in the same manner as the preparation of printing plate A except that a conventional fixing processing was carried out for 10 seconds with a 20°C fixer having the following composition prior to the irradiation:

Composition of Fixer:

| Water | 700 ml |
|---|---|
| Ammonium thiosulfate | 224 g |
| Sodium sulfite | 20 g |
| Water to make | 1,000 ml |

Continuous platemaking was performed by repeating the aforementioned processing operations with respect to each of the printing plate A having a size of 1003 mm × 800 mm and the printing plate B having the same size. In the case of the printing plate B, the printing plate obtained after making 100 printing plates (about 80 m$^2$) was stained with

black silver spots, probably due to the transfer from transport rollers. In the case of the printing plate A, on the other hand, the staining with black silver spots was not observed even after making 500 printing plates (about 400 m$^2$).

Printing was performed using a press, Heidel KOR, together with each of the initially made printing plates A and B. In both cases, the prints obtained had good qualities, including ink density, and both printing plates exhibited sufficient durability.

EXAMPLE 2

A 2S-class aluminum plate having a size of 1003 mm × 800 mm which had been mechanically grained in accordance with the method described in JP-A-48-33911 was dipped for 1 minute in a 2 % aqueous solution of sodium hydroxide kept at 40°C, and thereby part of the plate surface was etched. After washing, the plate was dipped for about 1 minute in a sulfuric acid-chromic acid mixed solution to reveal the surface of pure aluminum. The thus treated aluminum plate was dipped in 20 % sulfuric acid kept at 30°C, and was subjected to 2-minute anodic oxidation under a D.C. voltage of 1.5 V and an electric current density of 3 A/dm$^2$. Then, the aluminum plate was washed and dried. Photosensitive solution (I) as used in Example 1 was continuously applied so as to have a dry coverage of about 2 g/m$^2$ by means of a roll coater, thereby forming a non-silver photosensitive layer on the aluminum plate.

On the non-silver photosensitive layer, the same photosensitive solution (II) as used in Example 1 was continuously coated so as to have a dry coverage of about 5 g/m$^2$, and dried with hot air so that the air temperature was raised finally to 110°C. The thus-obtained photosensitive lithographic printing plate was designated as Sample No. 2.

Sample No. 2 was allowed to stand for 1 week under room temperature, and then subjected to the following plate-making processing: Sample No. 2 was exposed to light for 10 seconds via a negative film, which had been prepared by taking a photograph of letters on a reduced scale of about one-fifth, by means of an enlarger equipped with a 300 lux of light source and adjusted so as to magnify images 5 times. The thus exposed Sample No. 2 was subjected to the following processing by means of a processing apparatus having the structure shown in Fig. 5. In the first development section, the same developer (I) as used in Example 1 was warmed to 32°C and sprayed onto Sample No. 2 for 20 seconds. Subsequently, the sample was transported into the drying section, and made to pass therethrough in 5 seconds while air currents heated up to 50±10°C was blowing upon the sample surfaces at the current rate of 30 m$^3$/min. Just after passing the drying section, the sample was taken out and the weight thereof was measured. As for the developer content just after drying, its value determined by the equation mentioned hereinbefore was 33 %.

More specifically, when Weight I denotes the weight of Sample No. 2 before the processing, Weight II denotes the weight of Sample No. 2 at the completion of the drying operation after the development of the silver halide photosensitive layer, and Weight III denotes the weight of Sample No. 2 which had been subjected to the irradiation of the non-silver photosensitive layer, the elution of the whole silver halide photosensitive layer and the drying operation, successively, the developer content in the silver halide photosensitive layer on the measurement of Weight II is determined by the following equation;

$$\text{Developer content} = (\text{Weight II} - \text{Weight I}) / (\text{Weight I} - \text{Weight III})$$

As for the data obtained actually, Weight I was 900.58 g, Weight II was 901.92 g, and Weight III was 896.55 g.

The Sample No. 2 which had undergone the drying operation was made to pass through an ultraviolet irradiation section in 15 seconds. In the ultraviolet irradiation section, three mercury lamps of reflector type were installed. Thereafter, in an elution section, the irradiated sample was sprayed with a 40-45°C wash-out solution having the same composition as in Example 1, and then rubbed with brushes, followed by being made to pass between squeegee rollers. Further, the sample was transported into the second development section, and therein the same 30°C developer (II) as used in Example 1 was sprayed onto the sample for 30 seconds. The thus processed sample was washed in the washing section, and then coated with GP-1 by means of a gum coater 800 G (made by Fuji Photo Film Co., Ltd.) in the gumming section to provide a printing plate C.

On the other hand, a printing plate D was prepared in the same manner as above, except that a conventional fixing processing was carried out for 10 seconds with the same 20°C fixer as described in Example 1 instead of the above-described drying operation.

Continuous platemaking was performed by repeating the aforementioned processing operations with respect to each of the printing plate C having a size of 1003 mm × 800 mm and the printing plate D having the same size. In the case of the printing plate D, the printing plate obtained after making 100 printing plates (about 80 m$^2$) was stained with black silver spots, probably due to the transfer from transport rollers. In the case of the printing plate C, on the other hand, the staining with black silver spots was not observed even after making 500 printing plates (about 400 m$^2$).

Further, printing was performed using a press, Heidel KOR, together with each of the initially made printing plates C and D. In both cases, the prints obtained had good qualities, including ink density, and both printing plates exhibited sufficient durability.

16

In addition, platemaking was tried under a condition that the developer content was adjusted to 60 % by reducing the drying time. In this case, since drying of the silver halide photosensitive layer was uneven, the portions dried insufficiently were developed by the ultraviolet irradiation to blacken, and it occurred that the non-silver photosensitive layer underneath those portions remained although they were situated in the non-image area. On the other hand, when the developer content was reduced to 50 % by controlling the drying time, such a problem did not occur. Further, where the developer content was reduced to 30 % by prolonging the drying time in the case of preparing the printing plate C, though there was a trouble such that the developer was left in a dappled condition, the printing plate obtained had no problem in itself and showed qualities comparable or superior to the printing plate C.

While the invention has been described in detail and with reference to specific examples thereof, it will be apparent to one skilled in the art that various changes and modifications can be made therein without departing from the spirit and scope thereof.

## Claims

1. A method of processing a photosensitive lithographic printing plate comprising subjecting the photosensitive lithographic printing plate to imagewise exposure and development processing, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

   development processing the silver halide photosensitive layer,
   without fixing the developed silver halide photosensitive layer, irradiating the photosensitive lithographic printing plate with light for exposing the non-silver photosensitive layer through the silver halide photosensitive layer subjected to development processing and remaining unfixed,
   completing the irradiation such that the irradiation in every irradiated portion is within 3 seconds after the start of the irradiation,
   eluting the silver halide emulsion layer to remove, and
   finally development processing the non-silver halide photosensitive layer.

2. The method of claim 1, wherein the non-silver photosensitive layer is a positive working photosensitive layer containing a quinonediazide compound, and the silver halide photosensitive layer contains a negative working silver halide emulsion as a main component.

3. An apparatus for development processing a photosensitive lithographic printing plate subjected to image exposure, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

   (i) a first development section having only a means of feeding a developer to the imagewise exposed silver halide photosensitive layer, thereby performing the development,
   (ii) an irradiation section having a means of emitting high-energy ultraviolet light and irradiating the whole surface of the non-silver photosensitive layer with the high-energy ultraviolet light at a time or divisionally through the silver halide photosensitive layer remaining unfixed such that the irradiation in every irradiated portion is within 3 seconds after the start of the irradiation, to expose the whole plate at a time or part by part
   (iii) an elution section for eluting the silver halide photosensitive layer out to remove, and
   (iv) a second development section for developing the latent image formed in the non-silver photosensitive layer and dissolving the unnecessary portion to remove.

4. A method of processing a photosensitive lithographic printing plate comprising subjecting the photosensitive lithographic printing plate to imagewise exposure and development processing, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

   development processing the silver halide photosensitive layer,
   without fixing, drying the developed silver halide photosensitive layer,
   irradiating the non-silver photosensitive layer with light through the dried silver halide photosensitive layer,
   eluting the silver halide emulsion layer to remove, and
   finally development processing the non-silver halide photosensitive layer.

5. The method of claim 4, wherein the developed silver halide photosensitive layer is dried until the content of the developer of the silver halide photosensitive layer is reduced to 50 % or less.

6. The method of claim 4, wherein the non-silver photosensitive layer is a positive working photosensitive layer containing a quinonediazide compound, and the silver halide photosensitive layer contains a negative working silver halide emulsion as a main component.

7. The method of claim 5, wherein the non-silver photosensitive layer is a positive working photosensitive layer containing a quinonediazide compound, and the silver halide photosensitive layer contains a negative working silver halide emulsion as a main component.

8. An apparatus for development processing a photosensitive lithographic printing plate subjected to image exposure, the photosensitive lithographic printing plate comprising a hydrophilic support, a non-silver photosensitive layer being capable of forming a water-insoluble ink receptive image and formed on the hydrophilic support, and a silver halide photosensitive layer formed on the non-silver photosensitive layer, which comprises:

   (i) a first development section having only a means of feeding a developer to the imagewise exposed silver halide photosensitive layer, thereby performing the development,
   (ii) a drying section for drying the silver halide photosensitive layer, arranged subsequently to the development section,
   (iii) an irradiation section for irradiating the non-silver photosensitive layer with light through the dried silver halide photosensitive layer,
   (iv) an elution section for eluting the silver halide photosensitive layer out to remove, and
   (v) a second development section for developing the latent image formed in the non-silver photosensitive layer and dissolving the unnecessary portion to remove.

Fig. 1

EP 0 733 954 A2

Fig. 2

10

First
Development

Exposure

Elution

Second
Development

Washing  Gumming

Spray

31

Spray  Brush

Spray

Spray

Drying

20        30        40        50        60        70

Fig. 3

Width of Slit

Fig. 4

Fig. 5

First Development · Drying · Exposure · Elution · Second Development · Washing · Gumming

Spray · Hot-air Nozzle · UV Lump · Spray Brush · Spray · Spray

10′

20′ · 30′ · 41′ · 40′ · 50′ · 60′ · 70′ · 80′

Drying

Fig. 6

Fig. 7